Europäisches Patentamt

European Patent Office

Office européen des brevets

(19)

(11) EP 0 533 981 B1

(12) **EUROPÄISCHE PATENTSCHRIFT**

(45) Veröffentlichungstag und Bekanntmachung des Hinweises auf die Patenterteilung:
**24.07.1996 Patentblatt 1996/30**

(51) Int Cl.⁶: **H03J 3/32**

(21) Anmeldenummer: **91116462.2**

(22) Anmeldetag: **26.09.1991**

(54) **Empfangsgerät für Hochfrequenzsignale**

High frequency receiver

Récepteur haute fréquence

(84) Benannte Vertragsstaaten:
**DE ES FR GB IT**

(43) Veröffentlichungstag der Anmeldung:
**31.03.1993 Patentblatt 1993/13**

(73) Patentinhaber: **SIEMENS AKTIENGESELLSCHAFT**
**80333 München (DE)**

(72) Erfinder:
• **Scheckel, Bruno, Dipl.-Ing.**
**W-8017 Ebersberg (DE)**
• **Fenk, Joseph, Dipl.-Ing.**
**W-8057 Eching/Offenburg (DE)**

(56) Entgegenhaltungen:
**US-A- 4 837 852**

• **IEEE TRANSACTIONS ON CONSUMER ELECTRONICS. Bd. CE-32, Nr. 3, August 1986, NEW YORK US Seiten 302 - 304; GERD M. MAIER: 'Fully automatic self alignment of tv-tuners.'**
• **IEEE 1988 INTERNATIONAL CONFERENCE ON CONSUMER ELECTRONICS, 8.-10. JUNI ,S. 274-275, New York, USA. Heinz Lehning: "A TV-PLL-circuit for automatic tuner alignment."**

**Beschreibung**

Die Erfindung betrifft ein Empfangsgerät für Hochfrequenzsignale, insbesondere für Rundfunk- und Fernsehsignale, aber auch zum Beispiel für Funk- und Radarsignale.

Moderne Empfangsgeräte weisen heute im Empfangsteil ("Tuner") sogenannte PLL-Schaltungen ("PLL" = Phase-locked loop = Phasenregelschaltungen) auf mit einem spannungsgesteuerten Schwingkreis ("VCO" = Voltage controlled oscillator). Dies dient in Verbindung mit Filterkreisen einem Einstellen der Frequenz des gewünschten Senders durch den Benutzer. Ein solches System funktioniert jedoch nur dann, wenn die Filterkreise seitens des Geräteherstellers "abgeglichen" sind, d. h. wenn sie ein bestimmtes, auf die jeweilige Abstimmfrequenz optimal abgeglichenes Durchlaßverhalten aufweisen. In der Praxis erfolgt ein solcher Abgleich bislang manuell durch Verstellen von Spulen und Kondensatoren bzw. Ferritkernen in ihren Schalen. Dies ist jedoch sehr zeitaufwendig und somit sehr teuer in der Fertigung.

Theoretisch ist dies zwar mittlerweile auch digital-elektronisch möglich, wobei im Empfangsgerät eingebaute Mikrocomputer die Steuerung übernehmen sollen. Ein solches Empfangsgerät mit digital-elektronischem Abgleich ist beispielsweise in "IEEE Transactions on Consumer Electronics", Vol. CE-33, No. 3, August 1987, auf den Seiten 466 bis 472 unter dem Titel "An Integrated Circuit for Fast Automatic Alignment of TV Tuners" beschrieben. Danach enthält es in seinem Tunerteil (kurz "Tuner" genannt) eine PLL-Schaltung mit digitalen und analogen Funktionen und Bauelementen einschließlich eines spannungsgesteuerten Oszillators zur Erzeugung einer Oszillatorfrequenz sowie mehrere abzugleichende Filterkreise. Ein Teil des Tuners ist in Form einer (oder mehrerer) integrierter Schaltungen realisiert.

Ein anderer Teil ist in Form von diskreten Bauelementen realisiert, die der integrierten Schaltung als externe Beschaltung dienen.

Für den spannungsgesteuerten Oszillator ist in der Fernsehtechnik beispielsweise eine Abstimmspannung von kleiner 1 bis hin zu maximal 33 V notwendig, je nach der zu empfangenden, d. h. gewählten Senderfrequenz. Entsprechendes gilt für Abgleichspannungen, die die oben genannten Durchlaßkurven der Filterkreise bestimmen. Die Abgleichspannungen unterscheiden sich von der zugehörigen Abstimmspannung im allgemeinen um maximal +/- 3.5 V bis. +/- 5 V, abhängig vom jeweiligen Wert der Abstimmspannung. Zur Erzeugung dieser, für integrierte Schaltungen sehr hohen, Spannungen sind Operationsverstärker vorgesehen. Diese sollen entweder als externe Beschaltung zur oben genannten integrierten Schaltung ausgeführt sein oder aber in diese integriert (vergleiche z. B. die eingangs genannte Literaturstelle). In beiden Fällen würde zum einen viel Platz bzw. Chipfläche benötigt und zum anderen wiese auch jeder Operationsverstärker (wegen seiner relativ komplizierten Schaltung) eine für ihn individuelle Temperaturabhängigkeit auf, die beim Einsatz mehrerer Operationsverstärker, wie beim Stand der Technik üblich, zu Problemen führt bezüglich verschiedener Temperaturen des Empfangsgerätes ("Temperaturgang", "Driften"). Aus diesen Gründen und auch deshalb, weil eine solche Lösung in der Praxis noch teurer käme als manuelles Abgleichen, wird in der Industrie nach wie vor manuell abgeglichen; Empfangsgeräte mit digitalelektrischem Abgleich gibt es nicht.

Integrierte Schaltungen für (manuell abgleichbare) gattungsgemäße Empfangsgeräte zeigt auch das "Data Sheet 09.91" der Siemens AG mit dem Titel "ICs for Entertainment Electronics", "Tuner & PLL" bezüglich der dort vorgestellten integrierten Schaltungen mit den Bezeichnungen SDA 3302, SDA 3402X, SDA 3412X. Interessant sind dabei insbesondere die gezeigten Blockdiagramme und Anwendungsschaltungen (vergleiche z. B. Seiten 10, 21, 22, 30, 41).

Das Dokument, "IEEE Transactions on Consumer Electronics", CE-32, Aug. 1986, №3, Seiten 302-304 [MAIER], zeigt eine vollautomatische dynamische Abgleichung für ein Empfangsgerät.

Aufgabe der vorliegenden Erfindung ist es, ein gattungsgemäßes Empfangsgerät so weiterzubilden, daß es kompakter baubar ist und daß die einzelnen benötigten Spannungen (Abstimmspannung, Abgleichspannungen) genauer erzielbar sind. Insbesondere sollen sich durch Temperaturänderungen höchstens unwesentliche Änderungen bei und zwischen den einzelnen Spannungen ergeben. Weiterhin soll das zu schaffende Empfangsgerät einerseits digital-elektronisch abgleichbar sein und andererseits sollen trotzdem geringere Kosten anfallen sowohl gegenüber einem manuellen Abgleichen als auch gegenüber einem Empfangsgerät mit bisher bekanntem digital-elektronischem Abgleich.

Diese Aufgabe wird gelöst durch die Merkmale des Patentanspruches 1. Vorteilhafte Aus- und Weiterbildungen sind in Unteransprüchen gekennzeichnet.

Nachstehend wird die Erfindung anhand der Zeichnungen näher erläutert. Es zeigen:

| Figur 1 | ein erfindungsgemäßes Gerät mit einer Baugruppe, die den Tuner enthält, |
|---|---|
| Figur 2 | einen Tuner mit den für die Erfindung wichtigen Teilen, |
| Figur 3 | eine Übersicht über einen Teil der PLL-Schaltung des Tuners, |
| Figuren 4 bis 11 | vorteilhafte Aus- und Weiterbildungen der Elemente nach Figur 3. |

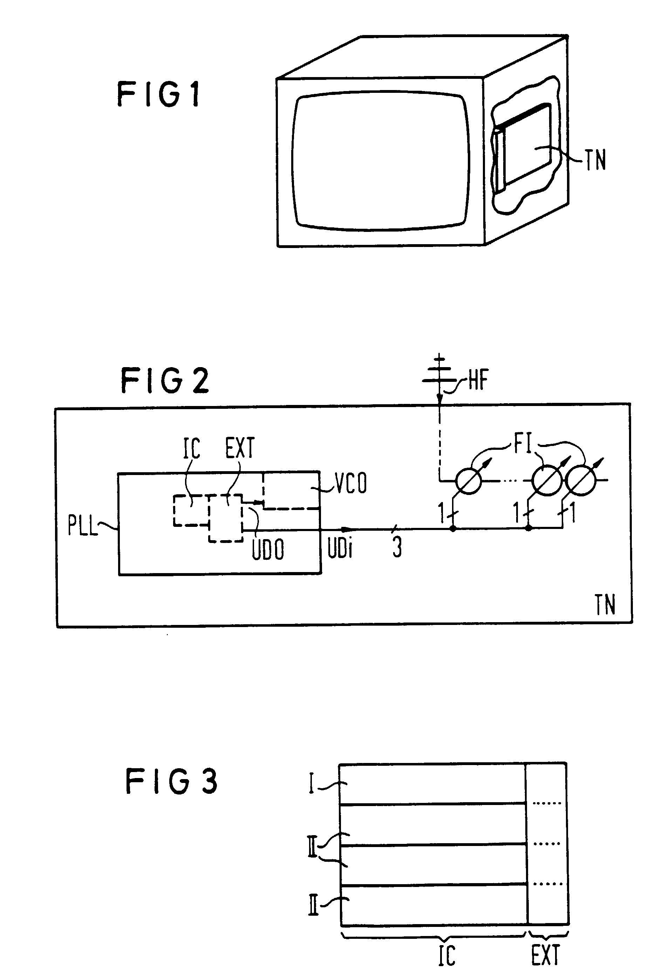

Figur 1 zeigt, stark schematisiert, ein erfindungsgemäßes Empfangsgerät, dargestellt als Fernsehgerät, mit einer den Tuner TN enthaltenden Baugruppe.

Der Tuner TN ist, ebenfalls stark schematisiert, in Figur 2 mit seinen für die vorliegende Erfindung maßgeblichen Teilen näher gezeigt: Dem Tuner TN ist, wie allgemein üblich, ein hochfrequentes Sendersignal HF zuführbar. Er enthält die PLL-Schaltung PLL sowie mehrere Filterkreise FI (symbolisch dargestellt sind drei Filterkreise FI). Jeder der drei Filterkreise FI ist durch eine (UD1, UD2, UD3) der Abgleichspannungen UDi angesteuert. Es ist selbstverständlich auch möglich, daß eine der Abgleichspannungen UDi auch mehr als einen Filterkreis FI ansteuert, wie dies z. B. in Figur 2 der eingangs genannten Literatur "IEEE ... " gezeigt ist.

Die PLL-Schaltung PLL enthält eine integrierte Schaltung IC sowie eine externe Beschaltung EXT der integrierten Schaltung IC. Sie enthält weiterhin einen (für die vorliegende Erfindung nicht näher interessierenden) spannungsgesteuerten Oszillator VCO. Dessen (Spannungs-)Steuerung erfolgt mit der Abstimmspannung UD0, die als Ausgangspotential der externen Beschaltung EXT entsteht, wie noch gezeigt wird.

Figur 3 zeigt schematisch eine Anordnung von Abstimmsektion I und Abgleichsektionen II der integrierten Schaltung IC sowie die externe Beschaltung EXT, wie sie für den in Figur 2 angegebenen Fall von drei Abgleichspannungen UDi notwendig ist, nämlich eine Abstimmsektion I zur Erzeugung der Abstimmspannung UD0, drei Abgleichsektionen II zur Erzeugung der Abgleichspannungen UD1...3 und eine externe Beschaltung EXT, die mit der Abstimmsektion I und den Abgleichsektionen II der integrierten Schaltung IC verbunden ist, was noch gezeigt wird.

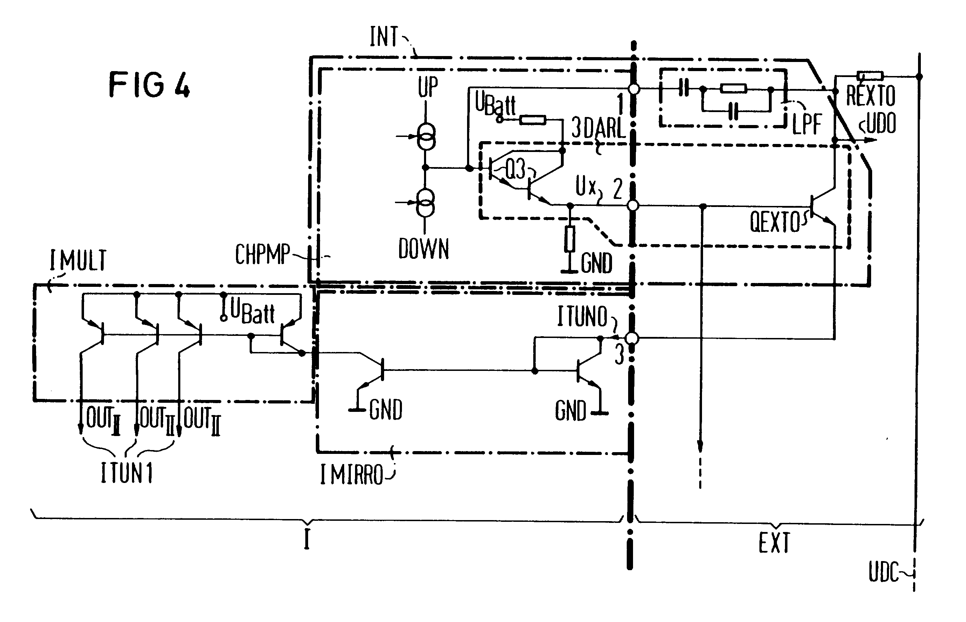

Figur 4 zeigt eine erste vorteilhafte Ausführungsform der Abstimmsektion I sowie denjenigen Teil der externen Beschaltung EXT, der mit der Abstimmsektion I elektrisch zusammenwirkt.

Die Abstimmsektion I enthält eine Ladungspumpe CHPMP zum Erzeugen einer Hilfsspannung Ux, eine erste Stromspiegelschaltung IMIRR0 zum Spiegeln eines ersten Abstimmstromes ITUN0 sowie eine Stromvervielfacherschaltung IMULT mit n Ausgängen OUT$_{II}$ zum Erzeugen von n zweiten Abstimmströmen ITUN1. Jeder der zweiten Abstimmströme ITUN1 ist wertemäßig gleich dem ersten Abstimmstrom ITUN0.

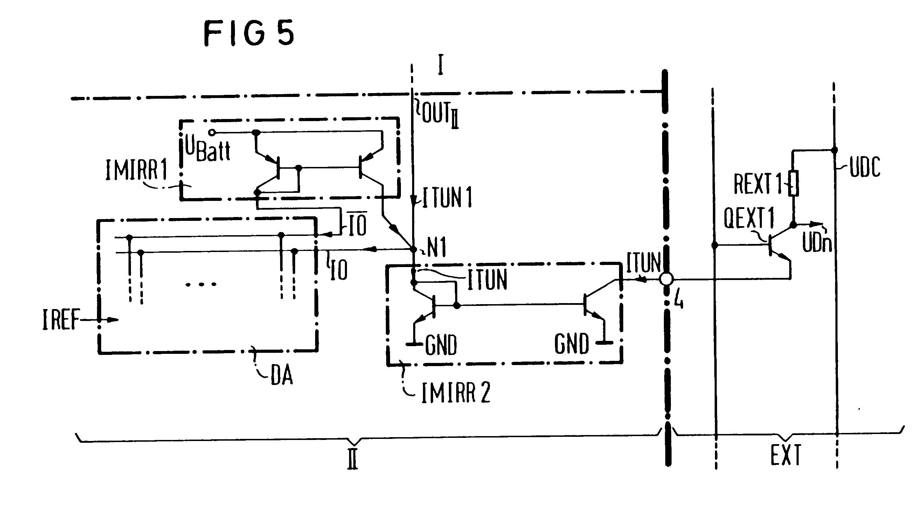

Als Ladungspumpe CHPMP kann eine übliche, nach dem Stand der Technik ausgestaltete, Ladungspumpe dienen, wie sie z. B. in Figur 5 des eingangs genannten Artikels "An Integrated ..." in "IEEE..." gezeigt ist oder wie sie auch in dem ebenfalls bereits genannten "Data Sheet 09.91" beispielsweise auf Seite 30 dargestellt ist.

Die Ladungspumpe CHPMP ist über zwei Ausgänge 1, 2 der integrierten Schaltung IC mit der externen Beschaltung EXT verbunden. Die externe Beschaltung EXT weist in dem Bereich, indem sie mit der Abstimmsektion I der integrierten Schaltung IC zusammenwirkt, ein Schleifenfilter LPF ("loop filter"), einen ersten Ausgangstransistor QEXT0 und einen ersten Widerstand REXT0 auf. Die externe Beschaltung EXT weist darüber hinaus noch ein Gleichspannungspotential UDC auf, dessen Wert mindestens gleich groß ist wie der größte im Betrieb auftretende Wert der Abstimmspannung UD0 und der ebenfalls mindestens gleich groß ist wie der größte im Betrieb auftretende Wert der Abgleichspannungen UDi. Im Falle eines Fernsehgerätes oder eines Videorekorders mit einem sogenannten Kabeltuner sind dies beispielsweise 30 bis 33 Volt.

Das Schleifenfilter LPF als solches ist ein im Stand der Technik übliches Schleifenfilter, bei dem einer Parallelschaltung aus einem Widerstand und einem Kondensator noch ein weiterer Kondensator in Reihe geschaltet ist (vgl. z. B. vorgenanntes "Data Sheet 09.91", Seiten 21, 22 in Verbindung mit Seite 11). Der eine Anschluß des Schleifenfilters LPF ist mit dem einen Ausgang 1 der integrierten Schaltung IC, und damit mit der Ladungspumpe CHPMP verbunden. Der andere Ausgang des Schleifenfilters LPF ist sowohl über den ersten Widerstand REXT0 mit dem Gleichspannungspotential UDC verbunden als auch mit dem Kollektor des ersten Ausgangstransistors QEXT0.

Die Basis des ersten Ausgangstransistors QEXT0 ist in der Ausführungsform nach Figur 4 mit dem anderen Ausgang 2 der integrierten Schaltung IC, und somit ebenfalls mit der Ladungspumpe CHPMP verbunden. Am anderen Ausgang 2 liegt im Betrieb die durch die Ladungspumpe CHPMP erzeugte Hilfsspannung Ux an.

Der Emitter des ersten Ausgangstransistors QEXT0 ist über einen Eingang 3 der integrierten Schaltung IC mit dem Eingang der ersten Stromspiegelschaltung IMIRR0 verbunden. Am Kollektor des ersten Ausgangstransistors QEXT0 entsteht im Betrieb die Abstimmspannung UD0 in Abhängigkeit von der Ladungspumpe, d. h. in Abhängigkeit von dem (bei jeder PLL-Schaltung bekanntlich vorhandenen) digitalen Anteil der PLL-Schaltung PLL, welcher wertemäßig durch jeden vom Bediener des Empfangsgerätes vorgenommenen Abstimmvorgang verändert wird. Der erste Ausgangstransistor QEXT0 ist also als sogenannter "Open Collector Transistor" beschaltet und ausgeführt, über dessen Kollektor-Emitter-Strecke je nach Wert der gewählten Abstimmspannung UD0, bis zu mehr als 30 V abfallen, wobei über den Emitter der erste Abstimmstrom ITUN0 fließt.

In der Ausführungsform nach Figur 4 bildet der erste Ausgangstransistor QEXT0 zusammen mit zwei Transistoren Q3 der Ladungspumpe CHPMP eine Dreifach-Darlington-Transistoreinheit 3DARL. Weiterhin bilden der erste Ausgangstransistor QEXT0 und das Schleifenfilter LPF der externen Beschaltung EXT zusammen mit der Ladungspumpe CHPMP der Abstimmsektion I der integrierten Schaltung IC einen aktiven Integrator INT.

Die erste Stromspiegelschaltung IMIRR0, die Bestandteil der Abstimmsektion I der integrierten Schaltung IC ist, weist eingangsseitig einen Transistor auf, dessen Kollektor mit seiner Basis verbunden ist und bei dem Kollektor und Basis mit dem Eingang 3 der integrierten Schaltung IC verbunden sind. Auf der anderen Seite der ersten Stromspiegelschaltung IMIRR0, d. h. an deren Ausgang, ist ebenfalls ein Transistor angeordnet, über dessen Kollektor ein gespiegelter Strom fließt, der wertemäßig gleich dem ersten Abstimmstrom ITUN0 ist, da die Basis dieses Transistors mit der Basis des Transistors am Eingang verbunden ist und da die Emitter der beiden Transistoren auf demselben Potential liegen.

Die Stromvervielfacherschaltung IMULT, die eingangsmäßig mit dem Ausgang der Stromspiegelschaltung IMIRR0 verbunden ist, ist da fakto eine Kombination von mehreren Stromspiegelschaltungen. Am Eingang der Stromvervielfacherschaltung IMULT ist ein Transistor angeordnet, bei dem, ebenso wie beim Eingang der ersten Stromspiegelschaltung IMIRR0, Kollektor und Basis miteinander verbunden sind. Der Transistor dient der Aufnahme des in der ersten Stromspiegelschaltung IMIRR0 gespiegelten Stromes. Ausgangsseitig sind mehrere Transistoren parallel geschaltet. Ihre Anzahl ist gleich der Anzahl n der Filtersektionen II, und damit gleich der Anzahl n der benötigten Abgleichspannungen UDi mit i = 1...n. Sowohl alle Emitter sowie auch alle Basen dieser Transistoren sind jeweils miteinander verbunden. Somit entsteht im Betrieb in jedem Kollektor dieser parallel geschalteten Transistoren, der gleichzeitig einer der Ausgänge $OUT_{II}$ der integrierten Schaltung IC ist, ein zweiter Abstimmstrom ITUN1, der jeweils gleich ist dem ersten Abstimmstrom ITUN0. Jeder dieser n zweiten Abstimmströme ITUN1 wird einer der n Abgleichssektionen II an einem jeweiligen Schaltungsknoten NI zugeführt (vgl. Figur 5).

Figur 5 zeigt eine vorteilhafte Ausführungsform einer der Abgleichsektionen II in Verbindung mit demjenigen Teil der externen Beschaltung EXT, der der betrachteten Abgleichsektion II zugeordnet ist.

Jede Abgleichsektion II enthält einen Digital-Analog-Wandler DA mit gewichteten Stromquellen (nicht detailliert dargestellt wegen der Übersichtlichkeit und da allgemeiner Stand der Technik, vgl. z. B. Datenbuch der Firma Motorola "Linear and Interface Integrated Circuits", 1984/85, Seiten 6-77, 6-93, die Baustainserie "MC10318" betreffend) und mit zwei komplamentären Stromausgängan IO, İO.

Dar Digitial-Analog-Wandler DA ist, wie allgemein üblich und ebenfalls aus Gründen dar Übersichtlichkeit nicht dargestellt, durch verschieden-wertige Digitalbits angesteuert. Weiterhin weist er noch einen Eingang für einen Referenzstrom IREF auf, nach dem sich, in Abhängigkeit von den angelegten Digitalbits, der Wert dar Ströme IO, $\overline{IO}$ an den beiden komplementäran Stromausgängen bestimmt. Der Referenzstrom IREF ist dezentral bei jeder einzelnen Abgleichssektion II erzeugbar oder aber zentral für alle Abgleichssektionen II in der Abstimmsektion I.

Jede Abgleichssektion II enthält weiterhin eine zweite (IMIRR1) und eine dritte Stromspiegalschaltung IMIRR2. Der eine Stromausgang IO des Digital-Analog-Wandlers DA ist mit dem Eingang der dritten Stromspiegelschaltung IMIRR2 und dem dieser Abgleichssektion II entsprechenden Ausgang $OUT_{II}$ der integrierten Schaltung IC unter Bildung des Schaltungsknotens NI verbunden. Der andere Stromausgang $\overline{IO}$ des Digital-Analog-Wandlers DA ist über die zweite Stromspiegelschaltung IMIRR1 mit dem Schaltungsknoten NI verbunden.

In den Ausführungsbeispielen nach den Figuren 4 und 5 sind die erste Stromspiegelschaltung IMIRR0 und die dritte Stromspiegelschaltung IMIRR2 gleich aufgebaut, wobei die Emitter der betreffenden Transistoren jeweils mit Masse GND verbunden sind. Im Gegensatz dazu ist die zweite Stromspiegalschaltung IMIRR1 dazu komplementär aufgebaut, d. h. die Emitter dar betroffenen Transistoren sind mit dem Versorgungspotential $U_{Batt}$ verbunden.

Ein am Ausgang der dritten Stromspiegelschaltung IMIRR2 entstehender Abgleichstrom ITUN der jeweiligen Abgleichssektion II ist aufgrund der Stromspiegelfunktion der dritten Stromspiegelschaltung IMIRR2 gleich demjenigen Strom, der vom Schaltungsknoten NI zur dritten Stromspiegelschaltung IMIRR2 fließt (in Figur 5 deshalb ebenfalls mit ITUN bezeichnet). Dieser jedoch ergibt sich aus dar Summe das jeweiligen zweiten Abstimmstromes ITUN1 und das aus der zweiten Stromspiegalschaltung IMIRR1 fließenden Stromes, der ja dem am anderen Stromausgang $\overline{IO}$ das Digital-Analog-Wandlers DA fließenden Stromes entspricht, und dar Differenz, die sich zum am einen Stromausgang IO das Digital-Analog-Wandlers DA fließenden Stromes ergibt. Verwendet man für die an den beiden komplementären Stromausgängen IO, $\overline{IO}$ fließenden Strömen ebenfalls die Bezugszeichen IO, $\overline{IO}$, so läßt sich folgende Formel angeben: $ITUN = ITUN1 + \overline{IO} - IO$, wobei $\overline{IO}$ im allgemeinen ungleich dem Wert von IO ist (abhängig von den an den Digital-Analog-Wandler DA anliegenden, zu wandelnden Bits).

Der am Ausgang dar dritten Stromspiegelschaltung IMIRR2 der jeweiligen Abgleichssektion II (welcher gleichzeitig ein weiterer Ausgang 4 der integrierten Schaltung IC ist) fließende Abgleichstrom ITUN entspricht also letztendlich (da der zweite Abstimmstrom ITUN1 gleich ist dem ersten Abstimmstrom ITUN0) dem über den Emitter des ersten Ausgangsstransistors QEXT0 der externen Beschaltung EXT fließenden ersten Abstimmstrom ITUN0, vermindert bzw. vergrößert um die Differenz der beiden Ströme IO, $\overline{IO}$, die an den beiden komplementären Stromausgängen IO, $\overline{IO}$ als jeweiligar Strom des jeweiligen Digital-Analog-Wandlers DA fließen.

Der Ausgang der dritten Stromspiegelschaltung IMIRR2 der jeweiligen Abgleichssektion II ist als ein jeweiliger weiterer Ausgang 4 der integrierten Schaltung IC mit dem Emitter eines von n (n = Anzahl dar Abgleichssektionen II) weiteren Ausgangsstransistoren QEXT1 der externen Beschaltung EXT verbunden. Die Basen aller dieser weiteren Ausgangsstransistoren QEXT1 sind alle miteinander und mit der Basis des einen externen Ausgangstransistors QEXT0 verbunden. Der Kollektor eines jeden der weiteren Ausgangstransistoren QEXT1 ist über einen weiteren Widerstand REXT1 mit dem Gleichspannungspotential UDC verbunden. Jeder weitere Ausgangstransistor QEXT1 bildet also mit dem zugehörigen weiteren Widerstand REXT1 einen Open-Collector-Ausgang. Am Kollektor eines jeden der n weiteren Ausgangstransistoren QEXT1 entsteht die für die jeweilige Abgleichssektion II (und den bzw. die) zugehörigen Filterkreise FI zum Abgleich benötigte Abgleichspannung $UD_i$ (i=1...n). Der Wert der jeweiligen Abgleichspannung $UD_i$ ist bekanntlich abhängig von der Abstimmspannung UD0 und vom zugehörigen Filterkreis FI. Er kann beispielsweise im Bereich zwischen 1.2 V und UDC liegen (UDC = Wert des Gleichspannungspotentials UDC, z. B. 33 V).

Mit einer solchen erfindungsgemäßen Anordnung lassen sich also alle die Abstimmspannung UD0 und die Abgleichsspannungen $UD_i$ bestimmbaren Elemente außer den Ausgangstransistoren QEXT0, QEXT1 platz- und stromsparend in einer integrierten Schaltung IC anordnen. Die beim Stand der Technik üblichen Operationsverstärker, die viel Platz beanspruchen und eine hohe Leistung verbrauchen, um die maximale Abstimm- (UD0) bzw. Abgleichspannung ($UD_i$) erreichen zu können, sind in Verbindung mit der vorteilhaften integrierten Schaltung IC im wesentlichen durch die platzsparenden Ausgangstransistoren QEXT0, QEXT1 ersetzt. Durch die Steuerung mittels dar Abstimm- und Abgleichströme ITUN0, ITUN1, ITUN ergibt sich eine hohe Genauigkeit bei niedrigen Spannungswerten (unter 5 V) innerhalb der integrierten Schaltung IC. Dies wird in erster Linie ermöglicht durch die Verwendung von verschiedenen Stromspiegelschaltungen IMIRR0, IMIRR1, IMIRR2 und der Stromvervielfacherschaltung IMULT, welche eine stromseitige Steuerung der gesamten Schaltungsanordnung ermöglichen. Die hohe Genauigkeit hat weiterhin bessere Filtereigenschaften zur Folge, da der Abgleich dadurch genauer erfolgen kann (und zwar im gesamten Bereich der empfangbaren Frequenzen). Weiterhin ist die aufgezeigte Lösung auch billiger als bislang übliches manuelles Abgleichen (hoh Lohnkosten!) und damit auch billiger als die (lediglich aus der Literatur) bekannte, nie in Serie realisierte digital-elektronische Lösung mit Operationsverstärkern.

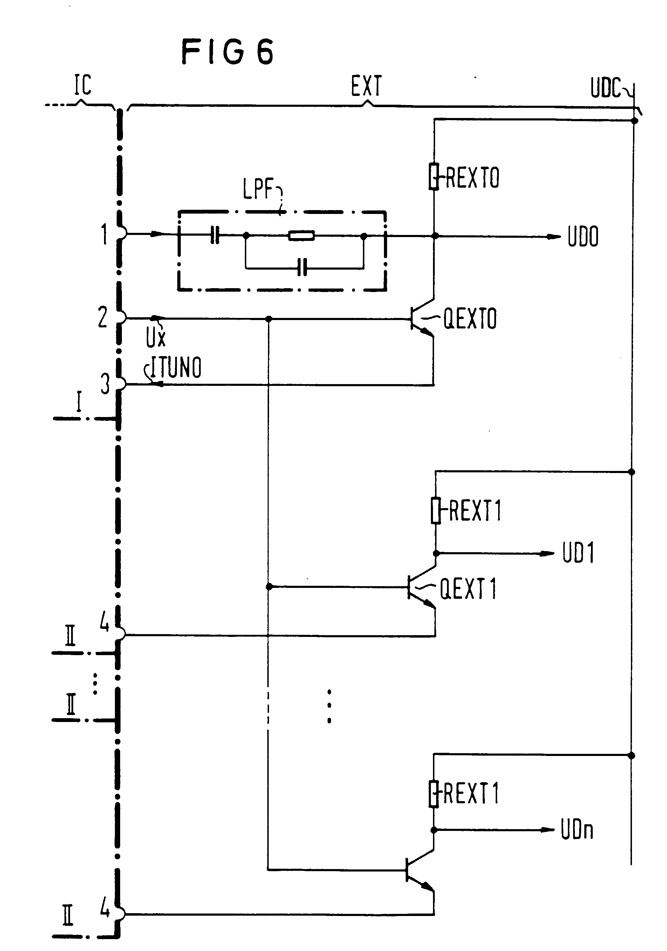

Figur 6 zeigt die externe Beschaltung EXT in der Ausführung, wie sie für die Erzeugung von einer Abstimmspannung UD0 und von n Abgleichspannungen UD1...n benötigt wird, wenn die Abstimmsektion I der integrierten Schaltung IC nach Figur 4 gestaltet ist.

Das Schleifenfilter LPF ist einerseits mit dem einen Ausgang 1 der integrierten Schaltung IC verbunden und andererseits über den einen Widerstand REXT0 mit dem Gleichspannungspotential UDC. Am Verbindungspunkt zwischen dem Schleifenfilter LPF und dem einen Widerstand REXT0, an dem auch der Kollektor das einen Ausgangstransistors QEXT0 angeschlossen ist, entsteht im Betrieb die Abstimmspannung UD0. Die Basis des einen Ausgangstransistors QEXT0 ist mit dem anderen Ausgang 2 der integrierten Schaltung IC verbunden; der Emitter ist mit dem Eingang 3 verbunden. Diese Anschlüsse 1 bis 3 der integrierten Schaltung führen alle zur Abstimmsektion I.

Für jede der n Abgleichsektionen II der integrierten Schaltung IC sind bei der externen Beschaltung EXT ein weiterer Ausgangsstransistor QEXT1 und ein weiterer Widerstand REXT1 vorgesehen, welcher einerseits mit dem Gleichsspannungspotential UDC verbunden ist und andererseits mit dem Kollektor des weiteren Ausgangstransistor QEXT1. Dies ist eine Open-Collector-Anordnung; die jeweilige Abgleichspannung $UD_i$ entsteht an der Verbindung zwischen dem Kollektor des jeweiligen weiteren Ausgangstransistors QEXT1 und dem jeweiligen weiteren Widerstand REXT1. Die Basen aller weiteren Ausgangstransistoren QEXT1 sind sowohl miteinander wie auch mit der Basis des einen Ausgangstransistors QEXT0 verbunden. Die Emitter jedes der weiteren Ausgangstransistoren QEXT1 sind mit einem jeweiligen weiteren Ausgang 4 der integrierten Schaltung IC verbunden, welcher jeweils einen der n Abgleichssektionen II zugeordnet ist.

Vorteilhafterweise sind alle Ausgangstransistoren QEXT0, QEXT1 und alle Widerstände REXT0, REXT1 gleich dimensioniert. Damit würde es sich an allen weiteren Ausgangstransistoren QEXT1 eine Abgleichsspannung $UD_i$ einstellen, die wertemäßig gleich ist der Abgleichsspannung UDO am einen Ausgangstransistor QEXT0, wenn die Abgleichsektionen II entweder keine Digital-Analog-Wandler DA enthielten oder wenn die Digital-Analog-Wandler DA dar einzelnen Abgleichssektionen II so betrieben würden, daß sich ihre Ströme IO, $\overline{IO}$ am jeweiligen Schaltungsknoten NI gegeneinander aufhöben. Dies ergibt sich aus der vorteilhaften Steuerung der Gesamtschaltung über Ströme anstatt über Spannungen. Der sich im Betrieb tatsächlich ergebende Unterschied zwischen den Werten dar jeweiligen Abgleichspannung $UD_i$ und der Abstimmspannung UD0 beruht somit ausschließlich auf der jeweilen digitalen Ansteuerung der einzelnen Digital-Analog-Wandler DA und der daraus resultierenden Referenz zwischen den beiden Strömen IO, $\overline{IO}$.

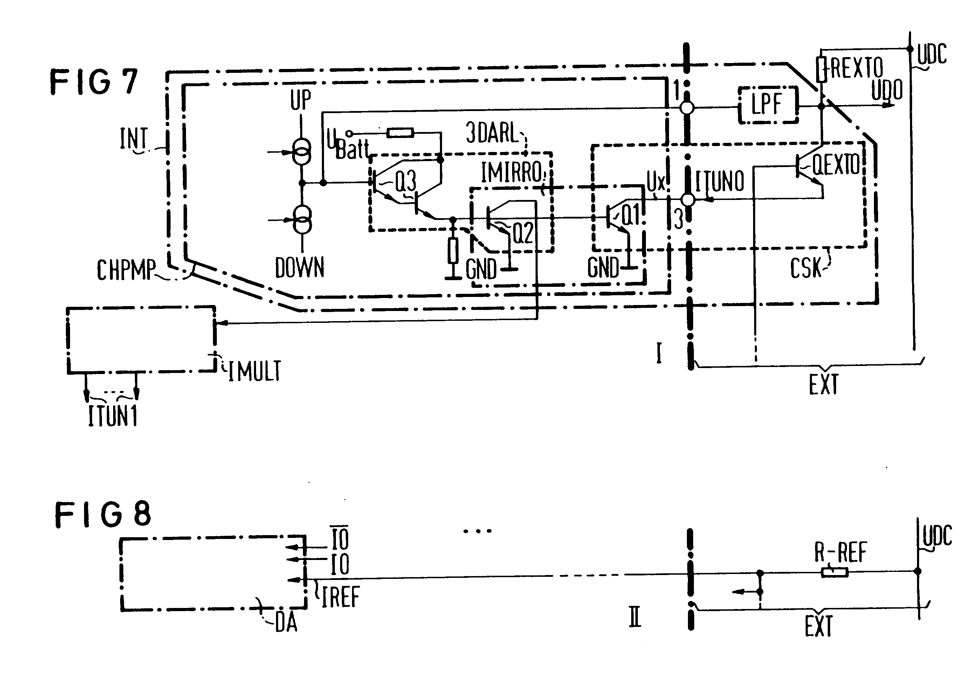

Figur 7 zeigt für die Erzeugung der Abstimmspannung UD0 eine weitere vorteilhafte Ausgestaltung der Ladungspumpe CHPMP samt erster Stromspiegelschaltung IMIRR0 und des dazugehörigen einen Ausgangstransistors QEXT0 der externen Beschaltung EXT. Nach Figur 7 enthält die erste Stromspiegelschaltung IMIRR0 zwei Transistoren Q1, Q2, deren Basen miteinander verbunden sind und deren Emitter sowohl miteinander als auch mit Masse GND verbunden sind. Der Kollektor das einen Transistors Q1, der als Eingang der ersten Stromspiegelschaltung IMIRR0 wirkt, ist über den Eingang 3 der integrierten Schaltung IC mit dem Emitter des einen Ausgangstransistors QEXT0 der extarnen Beschaltung EXT verbunden. Der eine Transistor Q1 bildet somit mit dem einen Ausgangstransistor QEXT0 zusammen eine Kaskode CSK (vgl. Tietze/Schank, Halbleiter-Schaltungstechnik, 9. Auflage,1989, S. 492).

Der Kollektor des anderen Transistors Q2 ist der Ausgang der ersten Stromspiegelschaltung IMIRR0, der, wie bei dar Ausführungsform nach Figur 4, mit der Stromvervielfacherschaltung IMULT verbunden ist. Der andere Transistor Q2 dar ersten Stromspiegelschaltung IMIRR0 bildet zusammen mit weiteren Transistoren Q3 dar Ladungspumpe CHPMP eine DreifachDarlington-Transistoreinheit 3DARL. Die erste Stromspiegelschaltung IMIRR0 ist also gleichzeitig funktioneller Bestandteil der Ladungspumpe CHPMP und somit auch des aktiven Integrators INT. Der Vorteil dieser Anordnung liegt darin, daß Abstimmspannungen UD0, und somit auch Abgleichsspannungen UDi möglich sind mit Werten, die minimal bei 0.8 V liegen. Dies ist möglich durch die Kaskodenschaltung CSK des einen Transistors Q1 und des einen Ausgangstransistors QEXT0. Bei der Ausführungsform nach Figur 4 sind nur Minimalwerte von ca. 1.2 V erreichbar.

Wie bezüglich Fig. 5 bereits erläutert, benötigt jeder Digital-Analog-Wandler DA einen Referenzstrom IREF, aus dem über die einzelnen Wandlerstufen die beiden Ströme IO und $\overline{\text{IO}}$ abgeleitet werden. Bei der bislang angegebenen Ausführungsform wurde nun angenommen, daß der Referenzstrom IREF jedes der Digital-Analog-Wandler DA individuell bei der jeweiligen Abgleichssektion II mittels einer Schaltung nach dem Stand der Technik (nicht dargestellt) erzeugt wird.

Figur 8 zeigt demgegenüber eine besonders vorteilhafte Ausführungsform für die Erzeugung der Referenzströme IREF. Danach ist der Referenzstrom IREF jedem einzelnen Digital-Analog-Wandler DA vom Gleichspannungspotential UDC aus über einen dem Digital-Analog-Wandler DA zugeordneten Referenzwiderstand R-REF zugeführt. Dieser kann in der externen Beschaltung EXT oder in der jeweiligen Abgleichsektion II angeordnet sein. Der Referenzwiderstand R-REF kann jedoch auch zentral für alle Digital-Analog-Wandler DA als Referenzstromquelle dienen. Dies ist in Figur 8 angedeutet, indem im Bereich des Referenzwiderstandes R-REF eine Verzweigung des Stromes angegeben ist. Der Anordnung nach Figur 8 liegen die Erkenntnis und die Idee zugrunde, alle Referenzströme IREF der Digital-Analog-Wandler DA vom Gleichspannungspotential UDC abzuleiten. Dies hat den Vorteil, daß die Referenzströme IREF aufgrund thermischer Einflüsse dieselben Änderungen erfahren wie das Gleichspannungspotential UDC und die durch die Widerstände REXT0, REXT1 der Ausgangstransistoren QEXT, QEXT1 und die Ausgangstransistoren QEXT0, QEXT1 selbst erzeugten Abstimm- und Abgleichströme, d. h. die Referenzströme IREF werden insgesamt unabhängig von den thermischen Einflüssen.

Übliche Abstimmspannungen UD0 weisen im allgemeinen Werte auf zwischen größer 0 V bis etwa 33 V.

Zugehörige Abgleichsspannungen UDi weisen im allgemeinen Warte auf, die sich z. B. bis zu +/- 3.5 V von der jeweiligen Abstimmspannung UD0 unterscheiden (allerdings ohne dabei die minimal mögliche Abstimmspannung zu unterschreiten und ohne die maximal mögliche Abstimmspannung zu überschreiten (letztere ist wertemäßig im allgemeinen gleich dem Gleichspannungspotential UDC bei der vorliegenden Erfindung). Es kann jedoch vorteilhaft sein, den Grenzwert von +/- 3.5 V ändern zu können auf beispielsweise +/- 5 V. Dies kann vorteilhaft sein, wenn die im Empfangsgerät verwendeten Filterkreise bei linearer Änderung der jeweiligen Abgleichspannung UDi nicht lineare Frequenzändarungen zur Folge haben (unterschiedliche Steilheiten der Frequenzänderung). Durch Umschalten der vorgenannten Grenzwerte können dann die Frequenzänderungen linearisiert werden.

In vorteilhafter Weiterbildung der Erfindung sind deshalb die Referenzströme IREF der Digital-Analog-Wandler DA wertemäßig von einem ersten Wert auf einen zweiten Wert umschaltbar. Das Umschalten kann digital (über ein Bit B eines im Empfangsgerät (heutzutage sowieso) vorhandenen Mikroprozessors und/oder Speichers) erfolgen. Es kann weiterhin zentral für alle Digital-Analog-Wandler DA in der Abstimmsektion I erfolgen oder dezentral in jeder einzelnen Abgleichsektion II.

Bei dezentraler Umschaltung wird der Wert IREF selbst umgeschaltet; bei zentraler Umschaltung der n-fache Wert (bei angenommenen n Digital-Analog-Wandlern DA, d.h. n Abstimmsektionen II, und unter der Annahme, daß die Referenzströme aller Digital-Analog-Wandler DA gleich sind).

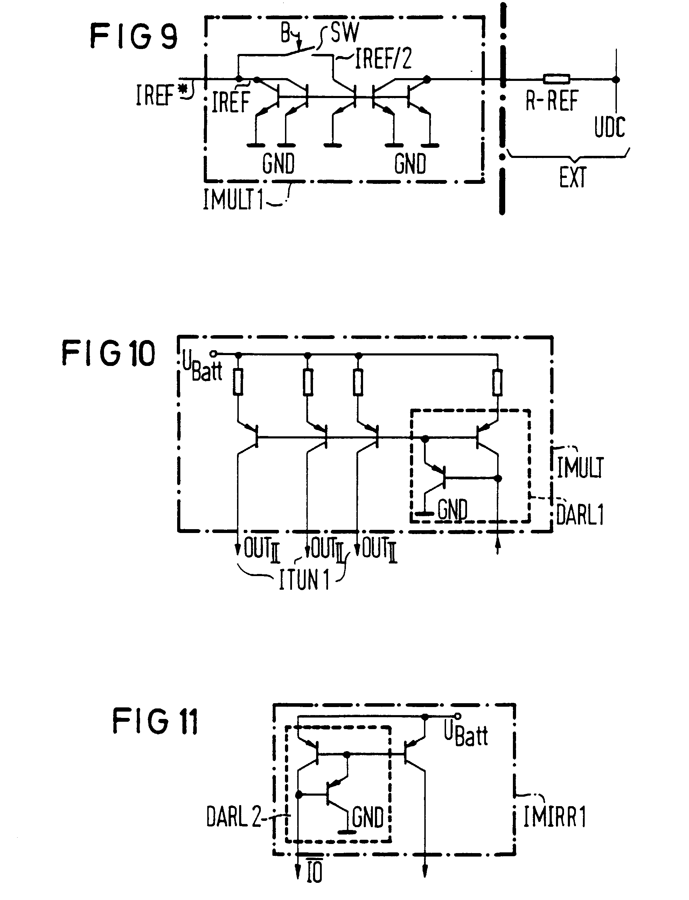

Figur 9 zeigt eine mögliche Schaltungsanordnung zum Umschalten des Referenzstromes IREF. Dabei ist angenomen, daß der Referenzstrom IREF zwischen seinem einfachen Wert und einem 3/2-fachen Wert umschaltbar sein soll. Nach Figur 9 ist das Gleichspannungspotential UDC, das ja der maximal möglichen Abstimmspannung UD0 entspricht, über den Referenzwiderstand R-REF mit dem Eingang einer weiteren Stromvervielfacherschaltung IMULT1 verbunden. Diese weist an ihrem Eingang zwei gleiche, zueinander parallel geschaltete Transistoren auf, deren Kollektoren mit dem Eingang verbunden sind. Ausgangsseitig sind zum einen weitere zwei parallel geschaltete Transistoren und ein einzelner Transistor vorgesehen, die gleich sind den eingangsseitigen Transistoren. Die Kollektoren der beiden weiteren parallel geschalteten Transistoren und der des einzelnen Transistors sind über ein als Schalter SW dargestelltes Schaltmittel (beispielsweise über einen sperrbaren Transistor) miteinander verbindbar unter Steuerung des bereits angesprochenen Bits B. Unter der Annahme, daß eingangsseitig ein Strom eines bestimmten Wertes, z. B. IREF, fließt, fließt in dem einen Fall, in dem der Schalter SW geöffnet ist auch ausgangsseitig ein Referenzstrom IREF* vom Werte IREF.

In dem anderen Fall, in dem der Schalter SW geschlossen ist, kommt dazu noch der Strom über den Kollektor des einzelnen Transistors, der IREF/2 beträgt. Damit fließt ausgangsseitig insgesamt ein Referenzstrom IREF* im Werte von 3/2.IREF. Auf diese Weise lassen sich nun die Grenzwerte für die Abgleichsspannungen UDi über die Digital-Analog-Wandler DA umschalten von beispielsweise UDi = UD0 +/- 3.5 V auf UDi = UD0 +/- 5 V.

Figur 10 zeigt eine vorteilhafte Ausgestaltung der Stromvervielfacher-Schaltung IMULT: Dabei sind eingangsseitig Transistoren in Darlington-Anordnung DARL1 vorgesehen.

Figur 11 zeigt eine vorteilhafte Ausgestaltung der zweiten Stromspiegelschaltung IMIRR1. Hier sind eingangsseitig ebenfalls Transistoren in Darlington-Anordnung DARL2 vorgesehen.

## Patentansprüche

1. Empfangsgerät für Hochfrequenz-Signale, enthaltend einen Tuner (TN)

   - mit einer PLL-Schaltung (PLL), welche einen durch eine Abstimmspannung (UD0) gesteuerten Oszillator (VCO) zur Erzeugung einer Oszillatorfrequenz sowie eine integrierte Schaltung (IC) und eine externe Beschaltung (EXT) der integrierten Schaltung (IC) enthält und
   - mit Filterkreisen (FI), deren Filterverhalten mittels Abgleichsspannungen (UDi, i=1...n) einstellbar ist,

   **gekennzeichnet durch** folgende Merkmale:

   a) die integrierte Schaltung (IC) enthält eine Abstimmsektion (I) und n Abgleichsektionen (II),
   b) die Abstimmsektion (I) enthält

   - eine Ladungspumpe (CHPMP) zum Erzeugen einer Hilfsspannung (Ux),
   - eine erste Stromspiegel-Schaltung (IMIRR0) zum Spiegeln eines ersten Abstimmstromes (ITUN0),
   - eine Stromvervielfacher-Schaltung (IMULT) mit n Ausgängen (OUT$_{II}$) zum Erzeugen von n zweiten Abstimmströmen (ITUN1),

   c) jede Abgleichsektion (II) enthält

   - einen Digital-Analog-Wandler (DA) mit komplementären Stromausgängen (IO, $\overline{IO}$),
   - eine zweite (IMIRR1) und eine dritte Stromspiegelschaltung (IMIRR2),
   - der eine Stromausgang (IO) des Digital-Analog-Wandlers (DA) ist unter Bildung eines Schaltungsknotens (N1) mit dem Eingang der dritten Stromspiegelschaltung (IMIRR2) und einem entsprechenden dar n Ausgänge (OUT$_{II}$) der Stromvervielfacherschaltung (IMULT) verbunden,
   - der andere Stromausgang ($\overline{IO}$) des Digital-Analog-Wandlers (DA) ist über die zweite Stromspiegelschaltung (IMIRR1) mit dem Schaltungsknoten (N1) verbunden,

   d) die externe Beschaltung (EXT) enthält

   - ein Schleifenfilter (LPF),
   - einen ersten Ausgangstransistor (QEXT0), an dessen Kollektor im Betrieb die Abstimmspannung (UDO) entsteht,
   - n weitere Ausgangstransistoren (QEXT1), an deren Kollektoren im Betrieb die Abgleichspannungen (UDi) entstehen,
   - die Ausgangstransistoren (QEXT0, QEXT1) sind kollektorseitig über Widerstände (REXT0, REXT1) mit einem Gleichspannungspotential (UDC) verbunden,
   - die Basen der Ausgangstransistoren (QEXT0, QEXT1) sind miteinander verbunden,
   - der Emitter des ersten Ausgangstransistors (QEXT0) ist mit der ersten Stromspiegelschaltung (IMIRRO) verbunden,
   - die Emitter der weiteren Ausgangstransistoren (QEXT1) sind mit dem Ausgang einer jeweiligen der dritten Stromspiegelschaltungen (IMIRR2) der Abgleichsektionen (II) verbunden,

   e) der erste Ausgangstransistor (QEXT0) und das Schleifenfilter (LPF) bilden zusammen mit der Ladungspumpe (CHPMP) der Abstimmsektion (I) der integrierten Schaltung (IC) einen aktiven Integrator (INT).

2. Empfangsgerät nach Anspruch 1,
   **dadurch gekennzeichnet,** daß
   Transistoren (Q3) der Ladungspumpe (CHPMP) zusammen mit dem ersten Ausgangstransistor (QEXT0) eine Dreifach-Darlington-Transistoreinheit (3DARL) bilden, wobei der erste Ausgangstransistor (QEXT0) an seiner Basis mit der Hilfsspannung (Ux) beaufschlagt ist und wobei dessen Emitter mit der ersten Stromspiegelschaltung (IMIRRO) eingangsmäßig verbunden ist.

3. Empfangsgerät nach Anspruch 2,
   **dadurch gekennzeichnet,** daß
   die erste Stromspiegelschaltung (IMIRR0) eingangsmäßig einen Transistor aufweist, dessen Kollektor mit seiner Basis verbunden ist.

4. Empfangsgerät nach Anspruch 1,
**dadurch gekennzeichnet**, daß
die erste Stromspiegelschaltung (IMIRR0) zwei Transistoren (Q1,Q2) enthält, deren Basen miteinander verbunden sind und deren Emitter miteinander verbunden sind, wobei der eine Transistor (Q1) mit dem ersten Ausgangstransistor (QEXT0) zusammen gleichzeitig eine Kaskode (CSK) bildet, wobei der andere Transistor (Q2) mit weiteren Transistoren (Q3) der Ladungspumpe (CHPMP) eine Dreifach-Darlington-Transistoreinheit (3DARL) bildet und wobei die erste Stromspiegelschaltung (IMIRR0) funktioneller Bestandteil der Ladungspumpe (CHPMP) ist.

5. Empfangsgerät nach einem der vorhergehenden Ansprüche,
**dadurch gekennzeichnet,** daß
dem Digital-Analog-Wandler (DA) ein zur Digital-Analog-Wandlung notwendiger Referenzstrom (IREF) über einen Referenzwiderstand (R-REF) zugeführt ist.

6. Empfangsgerät nach Anspruch 5,
**dadurch gekennzeichnet,** daß
die Referenzströme (IREF) aller Abgleichsektionen (II) über denselben Referenzwiderstand (R-REF) der externen Baschaltung (EXT) zugeführt sind.

7. Empfangsgerät nach einem dar vorhergehenden Ansprüche,
**dadurch gekennzeichnet,** daß
ein zur Digital-Analog-Wandlung notwendiger Referenzstrom (IREF) vom Gleichspannungspotential (UDC) abgeleitet ist.

8. Empfangsgerät nach einem der vorhergehenden Ansprüche,
**dadurch gekennzeichnet,** daß
dem Digital-Analog-Wandler (DA) ein zur Digital-Analog-Wandlung notwendiger Referenzstrom (IREF) wahlweise mit einem von wenigstens zwei verschiedenen Werten zuführbar ist.

9. Empfangsgerät nach Anspruch 8,
**dadurch gekennzeichnet,** daß
die Zuführung der verschiedenen Werte des Referenzstromes (IREF) mittels eines umschaltbaren weiteren Stromvervielfachers (IMULT1) erfolgt.

10. Empfangsgerät nach einem der vorhergehenden Ansprüche,
**dadurch gekennzeichnet,** daß
die mit den weiteren Ausgangstransistoren (QEXT1) verbundenen Widerstände (REXT1) alle denselben Wert aufweisen.

11. Empfangsgerät nach Anspruch 10,

**dadurch gekennzeichnet,** daß
der mit dem ersten Ausgangstransistor (QEXT0) verbundene Widerstand (REXT0) denselben Wert aufweist wie die Widerstände (REXT1) der weiteren Ausgangstransistoren (QEXT1).

12. Empfangsgerät nach einem der vorhergehenden Ansprüche,
**dadurch gekennzeichnet,** daß
die Stromvervielfacherschaltung (IMULT) der Abstimmsektion (I) eingangsmäßig Transistoren in Darlington-Anordnung (DARL1) aufweist.

13. Empfangsgerät nach einem der vorhergehenden Ansprüche,
**dadurch gekennzeichnet,** daß
die zweite Stromspiegelschaltung (IMIRR1) einer Abgleichsektion (II) eingangsmäßig Transistoren in Darlington-Anordnung (DARL2) aufweist.

**Claims**

1. Receiving device for radio-frequency signals, containing a tuner (TN)

   - having a phase-locked loop circuit (PLL), which contains an oscillator (VCO) which is controlled by a tuning voltage (UD0), for generating an oscillator frequency, as well as integrated circuit (IC) and external circuitry (EXT) of the integrated circuit (IC), and
   - having filter circuits (FI) whose filter response can be adjusted by means of trimming voltages (UDi, i=1...n),

   characterized by the following features:

   a) the integrated circuit (IC) contains a tuning section (I) and n trimming sections (II),
   b) the tuning section (I) contains

   - a charge pump (CHPMP) for generating an auxiliary voltage (Ux),
   - a first current mirror circuit (IMIRR0) for mirroring a first tuning current (ITUN0),
   - a current multiplier circuit (IMULT) having n outputs (OUT$_{II}$) for generating n second tuning currents (ITUN1),

   c) each trimming section (II) contains

   - a digital/analog converter (DA) having complementary current outputs (IO, $\overline{IO}$),
   - a second current mirror circuit (IMIRR1) and a third current mirror circuit (IMIRR2),
   - the one current output (IO) of the digital/analog converter (DA) is connected, forming a circuit node (N1) in the process, to the input of the third current mirror circuit (IMIRR2) and to a corresponding output of the n ouputs (OUT$_{II}$) of the current multiplier circuit (IMULT),

- the other current output ($\overline{IO}$) of the digital/analog converter (DA) is connected to the circuit node (N1) via the second current mirror circuit (IMIRR1),

d) the external circuitry (EXT) contains

- a loop filter (LPF),
- a first output transistor (QEXT0), at the collector of which the tuning voltage (UD0) is produced during operation,
- n further output transistors (QEXT1), at the collectors of which the trimming voltages (UDi) are produced during operation,
- the output transistors (QEXT0, QEXT1) are connected by their collectors to a DC voltage potential (UDC) via resistors (REXT0, REXT1),
- the bases of the output transistors (QEXT0, QEXT1) are connected to one another,
- the emitter of the first output transistor (QEXT0) is connected to the first current mirror circuit (IMIRR0),
- the emitters of the further output transistors (QEXT1) are connected to the output of a respective third current mirror circuit of the third current mirror circuits (IMIRR2) of the trimming sections (II),

e) the first output transistor (QEXT0) and the loop filter (LPF) form, together with the charge pump (CHPMP) of the tuning section (I) of the integrated circuit (IC) an active integrator (INT).

2. Receiving device according to Claim 1, characterized in that transistors (Q3) of the charge pump (CHAMP) form, together with the first output transistor (QEXT0), a triple Darlington transistor unit (3DARL), the auxiliary voltage (Ux) being applied to the base of the first output transistor (QEXT0), and the emitter of the latter being connected to the input of the first current mirror circuit (IMIRR0).

3. Receiving device according to Claim 2, characterized in that the first current mirror circuit (IMIRR0) has at its input a transistor whose collector is connected to its base.

4. Receiving device according to Claim 1, characterized in that the first current mirror circuit (IMIRR0) contains two transistors (Q1, Q2) whose bases are connected to one another and whose emitters are connected to one another, the one transistor (Q1) simultaneously forming a cascode (CSK) together with the first output transistor (QEXT0), the other transistor (Q2) forming a triple Darlington transistor unit (3DARL) with further transistors (Q3) of the charge pump (CHPMP), and the first current mirror circuit (IMIRR0) being a functional component part of the charge pump (CHPMP).

5. Receiving device according to one of the preceding claims, characterized in that a reference current (IREF) which is necessary for the digital/analog conversion is fed to the digital/analog converter (DA) via a reference resistor (R-REF).

6. Receiving device according to Claim 5, characterized in that the reference currents (IREF) of all of the trimming sections (II) are fed via the same reference resistor (R-REF) of the external circuitry (EXT).

7. Receiving device according to one of the preceding claims, characterized in that a reference current (IREF) which is necessary for the digital/analog conversion is derived from the DC voltage potential (UDC).

8. Receiving device according to one of the preceding claims, characterized in that the digital/analog converter (DA) can be supplied with a reference current (IREF) which is necessary for the digital/analog conversion and optionally has one of at least two different values.

9. Receiving device according to Claim 8, characterized in that the different values of the reference current (IREF) are supplied by means of a further current multiplier (IMDLT1), which can be changed over.

10. Receiving device according to one of the preceding claims, characterized in that the resistors (REXT1) connected to the further output transistors (QEXT1) all have the same value.

11. Receiving device according to Claim 10, characterized in that the resistor (REXT0) connected to the first output transistor (QEXT0) had the same value as the resistors (REXT1) of the further output transistors (QEXT1).

12. Receiving device according to one of the preceding claims, characterized in that the current multiplier circuit (IMULT) of the tuning section (I) has, at its input, transistors in a Darlington arrangement (DARL1).

13. Receiving device according to one of the preceding claims, characterized in that the second current mirror circuit (IMIRR1) of a trimming section (II) has, at its input, transistors in a Darlington arrangement (DARL2).

## Revendications

1. Appareil de réception de signaux haute fréquence comprenant un dispositif (TN) d'accord

   - comportant un circuit de boucle à verrouillage de phase (PLL), qui comprend un oscillateur (VCO) commandé par une tension (UD0) d'accord pour la production d'une fréquence d'oscillation ainsi qu'un circuit intégré (IC) et un branchement externe (EXT) du circuit intégré (IC) et
   - des circuits (FI) de filtrage, dont la caractéristique de filtrage peut être réglée au moyen de tensions (UDi, i=1 à n) d'ajustage,

   caractérisé par les particularités suivantes :

   a) le circuit intégré (IC) comprend une section (I) d'accord et n sections (II) d'ajustage,
   b) la section (I) d'accord comprend

   - une pompe (CHPMP) de charge pour la production d'une tension (Ux) auxiliaire,
   - un premier circuit (IMIRR0) de miroir de courant destiné faire la symétrie d'un premier courant (ITUN0) d'accord,
   - un circuit (IMULT) de multiplication de courant comportant n sorties ($OUT_{II}$) pour la production de n seconds courants (ITUN1) d'accord,

   c) chaque section (II) d'ajustage comprenant

   - un convertisseur (DA) numérique-analogique à sorties (IO, $\overline{IO}$), complémentaires de courant,
   - un second circuit (IMIRR1) de miroir de courant et un troisième circuit (IMIRR2) de miroir de courant,
   - l'une (IO) des sorties de courant du convertisseur (DA) numérique-analogique est reliée à l'entrée du troisième circuit (IMIRR2) de miroir de courant et à une sortie correspondante parmi les n sorties ($OUT_{II}$) du circuit (IMULT) de multiplication de courant, tout en formant un noeud (N1) de circuit,
   - l'autre sortie ($\overline{IO}$) de courant du convertisseur (DA) numérique-analogique est reliée par l'intermédiaire du second circuit (IMIRR1) de miroir de courant au noeud (N1) de circuit,

   d) le branchement externe (EXT) comprend

   - un filtre (LPF) de boucle,
   - un premier transistor (QEXT0) de sortie, au collecteur duquel apparaît en fonctionnement la tension (UD0) d'accord,
   - n autres transistors (QEXT1) de sortie, aux collecteurs desquels apparaissent en fonctionnement les tensions (UDi) d'ajustage,
   - les transistors (QEXT0, QEXT1) de sortie sont reliés du côté collecteur par l'intermédiaire de résistances (REXT0, REXT1) à un potentiel (UDC) de tension continue,
   - les bases des transistors (QEXT0, QEXT1) de sortie sont reliées l'une à l'autre,
   - l'émetteur du premier transistor (QEXT0) de sortie est relié au premier circuit (IMIRR0) de miroir de courant,
   - les émetteurs des autres transistors (QEXT1) de sortie sont reliés à la sortie de l'un des troisièmes circuits (IMIRR2) de miroir de courant des sections (II) d'ajustage,

   e) le premier transistor (QEXT0) de sortie et le filtre (LPF) de boucle forme conjointement avec la pompe (CHPMP) de charge de la section (I) d'accord du circuit intégré (IC) un intégrateur actif (INT).

2. Appareil de réception suivant la revendication 1, caractérisé en ce que
   des transistors (Q3) de la pompe (CHPMP) de charge forment conjointement avec le premier transistor (QEXT0) de sortie une unité (3DARL) de transistors Darlington triple, le premier transistor (QEXT0) de sortie recevant sur sa base la tension (Ux) auxiliaire et son émetteur étant relié à une entrée du premier circuit (IMIRR0) de miroir de courant.

3. Appareil de réception suivant la revendication 2, caractérisé en ce que
   le premier circuit (IMIRR0) de miroir de courant comporte à son entrée un transistor, dont le collecteur est relié à la base.

4. Appareil de réception suivant la revendication 1, caractérisé en ce que
   le premier circuit (IMIRR0) de miroir de courant comprend deux transistors (Q1, Q2), dont les bases sont reliées l'une à l'autre et dont les émetteurs sont reliés l'un à l'autre, l'un (Q1) des transistors formant conjointement avec le premier transistor (QEXT0) de sortie en même temps un circuit cascode (CSK), l'autre transistor (Q2) formant avec d'autres transistors (Q3) de la pompe (CHPMP) de charge une unité (3DARL) de transistors Darlington triple et le premier circuit (IMIRR0) de miroir de courant fait partie d'un point de vue fonctionnel de la pompe (CHPMP) de charge.

5. Appareil de réception suivant l'une des revendications précédentes, caractérisé en ce que un courant (IREF) de référence nécessaire à la conversion numérique-analogique est envoyé au convertisseur (DA) numérique-analogique par l'intermédiaire d'une résistance (R-REF) de référence.

6. Appareil de réception suivant la revendication 5, caractérisé en ce que les courants (IREF) de référence sont envoyés à toutes les sections (II) d'ajustage par l'intermédiaire de la même résistance (R-REF) de référence du branchement externe (EXT).

7. Appareil de réception suivant l'une des revendications précédentes, caractérisé en ce que un courant (IREF) de référence nécessaire à la conversion numérique-analogique est obtenu à partir du potentiel (UDC) de tension continue.

8. Appareil de réception suivant l'une des revendications précédentes, caractérisé en ce que un courant (IREF) de référence nécessaire à la conversion numérique-analogique ayant au choix l'une parmi au moins deux valeurs différentes peut être envoyé au convertisseur (DA) numérique-analogique.

9. Appareil de réception suivant la revendication 8, caractérisé en ce que l'envoi des valeurs différentes du courant (IREF) de référence s'effectue au moyen d'un autre multiplicateur (IMULT1) de courant pouvant être commuté.

10. Appareil de réception suivant l'une des revendications précédentes, caractérisé en ce que les résistances (REXT1) reliées aux autres transistors (QEXT1) de sortie ont toutes la même valeur.

11. Appareil de réception suivant la revendication 10, caractérisé en ce que la résistance (REXT0) reliée au premier transistor (QEXT0) de sortie a la même valeur que les résistances (REXT1) des autres transistors (QEXT1) de sortie.

12. Appareil de réception suivant l'une des revendications précédentes, caractérisé en ce que le circuit (IMULT) de multiplication de courant de la section (I) d'accord comporte, en entrée, des transistors en disposition (DARL1) Darlington.

13. Appareil de réception suivant l'une des revendications précédentes, caractérisé en ce que le second circuit (IMIRR1) de miroir de courant d'une section (II) d'ajustage comporte, en entrée, des transistors en disposition (DARL2) Darlington.

EP 0 533 981 B1

FIG1

FIG 2

FIG 3

12

FIG 4

FIG 5

# FIG 6

FIG 7

FIG 8

EP 0 533 981 B1

FIG 9

FIG 10

FIG 11